**Europäisches Patentamt**

**European Patent Office**

**Office européen des brevets**

(19)

(11) Veröffentlichungsnummer : **0 129 020**
**B1**

(12)

# EUROPÄISCHE PATENTSCHRIFT

(45) Veröffentlichungstag der Patentschrift :
11.11.87

(21) Anmeldenummer : **84104544.6**

(22) Anmeldetag : **28.08.82**

(60) Veröffentlichungsnummer der früheren Anmeldung
nach Art. 76 EPÜ : **0074550**

(51) Int. Cl.⁴ : **H 01 L 41/08, F 02 M 41/14**

(54) **Piezoelektrischer Steuerblock in Verbindung mit einer Kraftstoffeinspritzanlage.**

(30) Priorität : **08.09.81 DE 3135494**

(43) Veröffentlichungstag der Anmeldung :
**27.12.84 Patentblatt 84/52**

(45) Bekanntmachung des Hinweises auf die Patenterteilung : **11.11.87 Patentblatt 87/46**

(84) Benannte Vertragsstaaten :
**DE FR GB IT**

(56) Entgegenhaltungen :
**DE-A- 3 103 061**
**DE-B- 2 542 228**
**FR-A- 2 107 403**
**FR-A- 2 228 944**
**FR-A- 2 411 533**
**FR-A- 2 425 599**
**US-A- 3 635 016**

(73) Patentinhaber : **ROBERT BOSCH GMBH**
**Postfach 50**
**D-7000 Stuttgart 1 (DE)**

(72) Erfinder : **Babitzka, Rudolf**
**Birkenweg 11**
**D-7141 Kirchberg (DE)**
Erfinder : **Beck, Walter**
**Vöhingerweg 3**
**D-7141 Schwieberdingen (DE)**

**Beschreibung**

Stand der Technik

Die Erfindung betrifft einen piezoelektrischen Steuerblock nach dem ersten Teil des Hauptanspruchs. Bekannte Steuerblöcke dieser Art (FR-A-2 228 944) arbeiten mit einem Piezo-Steller-Stabel, der zwar relativ große Stellkräfte aufbringt, mit dem aber nur relativ kleine Stellwege abnehmbar sind. Um zu brauchbaren Stellwegen eines Fördermengenstellglieds zu kommen, muß die Stellbewegung übersetzt werden, z. B. hydraulisch, was einen verteuernden Mehraufwand bedeutet.

Vorteile der Erfindung

Der erfindungsgemäße piezoelektrische Steuerblock mit den kennzeichnenden Merkmalen des Hauptanspruchs hat demgegenüber den Vorteil, daß durch ihn eine direkte Steuerung des Fördermengenstellglieds möglich wird.

Besonders vorteilhaft ist der einfache Aufbau des Steuerblocks, der in sich dennoch die Möglichkeit einer beliebigen Dämpfung der Stellbewegung bietet.

Durch die in den Unteransprüchen aufgeführten Maßnahmen sind vorteilhafte Weiterbildungen und Verbesserungen des im Hauptanspruch angegebenen piezoelektrischen Steuerblocks möglich.

Zeichnung

Ein Ausführungsbeispiel des Erfindungsgegenstandes ist in der Zeichnung dargestellt und in der nachfolgenden Beschreibung näher erläutert. Es zeigen Figur 1 einen Steuerblock aus mehreren piezo-elektrisch steuerbaren Biegestellern, Figur 2 eine schematische Darstellung der Schnittstellen eines elektronischen Steuergerätes mit Eingängen zu verschiedenen Parametern und Ausgängen für Steuerimpulse, u. a. für die Steuerung des Piezostellers und Figuren 3 bis 6 Einzelheiten der Biegesteller.

Beschreibung des Ausführungsbeispiels

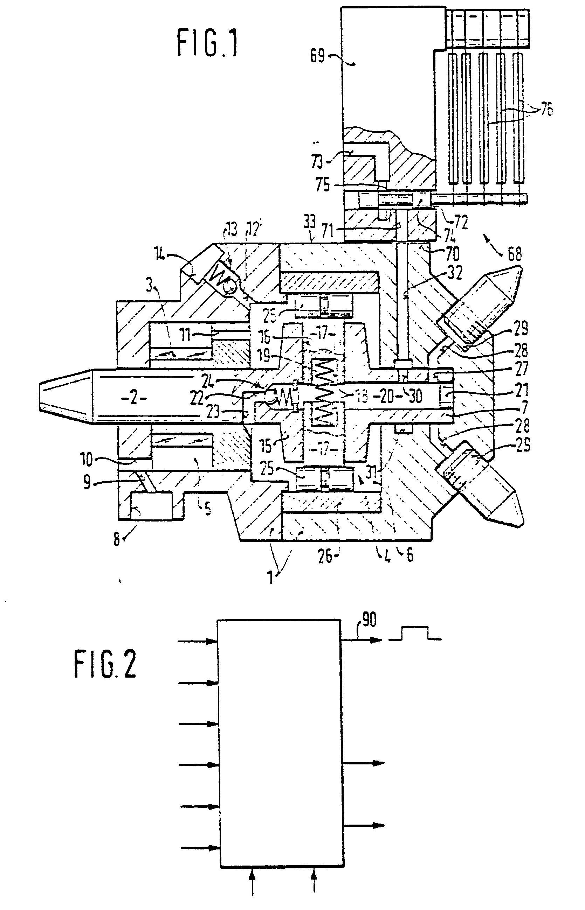

Im Ausführungsbeispiel gemäß Figur 1 ist in einem zweiteiligen Gehäuse 1 eine Welle 2 gelagert. Außerdem nimmt das Gehäuse 1 eine mit der Welle 2 verbundene Flügelzellenpumpe 3 und eine ebenfalls mit der Welle 2 verbundene Doppelkolbenpumpe 4 in entsprechenden Räumen 5 und 6 auf. Das doppelkolbenpumpenseitige Ende der Welle 2 ist als Verteiler 7 ausgebildet. Das Gehäuse 1 besitzt weiter einen Anschluß 8 für eine Kraftstoffzuleitung, von dem aus Kanäle 9 und 10 zum Raum 5 der Flügelzellenpumpe 3 führen. Ein Kanal 11 verbindet die Druckseite des Raumes 5 mit dem Raum 6. Vom Raum 6 führt ein Kanal 12 über ein Druckbegrenzungsventil 13 zu einem Anschluß 14 für eine Kraftstoffrücklaufleitung. Im Raum 6 ist ein Flansch 15 der Welle 2 angeordnet, der eine in Durchmesserrichtung dieses Flansches verlaufende zylindrische Bohrung 16 aufweist. In dieser zylindrischen Bohrung 16 ist ein Kolbenpaar 17 verschiebbar gelagert. Die Kolben dieses Kolbenpaares 17 besitzen in ihren einander zugewendeten Böden Bohrungen 18, in die eine Schraubendruckfeder 19 unter Vorspannung eingebracht ist. Eine Längsbohrung 20 in der Welle 2 ist stirnseitig durch einen Stopfen 21 abgedichtet. Sie setzt sich quer durch die Bohrung 16 zum antriebsseitigen Ende der Welle 2 hin fort, bis sie über einen Konus in eine Axialbohrung 22 übergeht. Diese Axialbohrung 22 ist mittels einer Radialbohrung 23 mit dem Raum 6 verbunden. In dem Übergangskonus von der Längsbohrung 20 zur Axialbohrung 22 ist die Kugel eines Rückschlagventils 24 eingepaßt. Jeder Kolben des Kolbenpaares 17 stützt sich außen gegen ein Rollenpaar 25 ab. Die Rollenpaare 25 werden damit gegen die innere, kurvenförmige Fläche eines Kurvenringes 26 gepreßt. Kurz vor dem Stopfen 21 besitzt die Welle 2 eine Radialbohrung 27. Diese Radialbohrung 27 kann je nach Drehstellung der Welle 2 mit einem von mehreren stirnförmig um die Welle herum angeordneten Kanälen 28 fluchten. Die Kanäle 28 führen über Anschlußstellen 29 zu den Einspritzdüsen. Eine weitere Radialbohrung 30 in der Welle 2 führt in eine Ringnut 31 in der das Verteilerende 7 der Welle 2 aufnehmenden Bohrung im Gehäuse 1. Von dieser Ringnut 31 führt ein Kanal 32 zu einer Anschlußfläche 33 am Gehäuse 1.

An diese Anschlußfläche 33 ist ein aus mehreren piezoelektrisch steuerbaren Biegestellern zusammengesetzter Steuerblock 68 angesetzt. Dieser Steuerblock 68 umfaßt einen Trägerkörper 69 mit einer Anschlußfläche 70. Den Anschluß zum Kanal 32 bildet ein Kanal 71. Dieser Kanal 71 führt über eine Bohrung 72 und einen weiteren Kanal 73 zur Rückführleitung zum Kraftstoffbehälter. In der Bohrung 72 lagert ein Steuerschieber 74, der die Aufgabe übernimmt eine Verbindung zwischen den Kanälen 71 und 73 zu unterbinden oder zuzulassen. Er besitzt eine Eindrehung, die mit 75 bezeichnet ist. Ein Ende dieses Steuerschiebers 74 ragt aus der Bohrung 72 heraus und ist verbunden mit den freien Enden mehrerer piezoelektrischer Biegesteller 76. Diese Biegesteller sind an ihrem anderen Ende festgelegt in einer Säule 77, die ihrerseits fest verbunden ist mit dem Trägerkörper 69.

Im hier beschriebenen Beispiel gemäß Figur 1 ist der Steuerschieber 74 in der Freigabestellung gezeigt, in der der Kraftstoff ungehindert die Kanäle 71 und 73 durchfließen kann. In dieser Stellung des Steuerschiebers 74 wird nicht eingespritzt. Die gezeigte Stellung ist vorzugsweise die Ruhestellung der Biegesteller 76, in der diese nicht an Spannung liegen. Werden sie an Spannung gelegt, treiben sie den Steuerschieber 74 in Schließstellung zum Kanal 71. Damit kann über den Verteiler 7 eingespritzt werden.

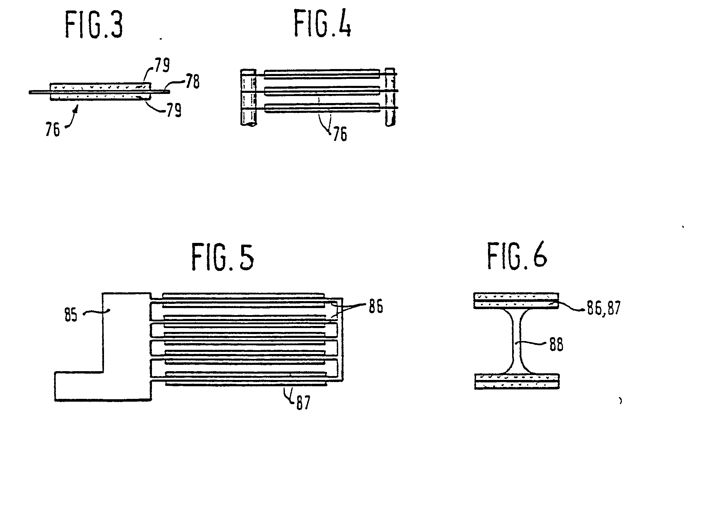

Figur 3 zeigt einen einzelnen Biegesteller 76, der aus einem Metallstreifen 78 und beiderseits dieses Metallstreifens 78 aufgebrachten (z. B. gesinterten) Keramikplatten 79 besteht.

Figur 4 zeigt, wie man die Biegesteller 76 nach Figur 3 hintereinanderreihen kann, ohne daß man sich hiermit begnügen müßte. Es ist selbstverständlich auch möglich, mehrere solcher Biegesteller 76 nebeneinander anzuordnen.

Figur 5 zeigt einen Trägerbauteil aus Kunststoff oder Metall 85 mit Stegen 86, die wiederum beidseitig mit Keramikstreifen 87 besetzt sind.

Zur Dämpfung eines solchen Stellers sind zwischen die im Abstand voneinander angeordneten Biegesteller 76 bzw. 86/87 Reibstege 88 eingebracht, wie es in Figur 6 im Schnitt gezeigt ist.

Das gesteuerte Anlegen von Spannung an die piezo-elektrischen Steller kann vorzugsweise mit einem an sich bekannten Steuergerät erfolgen, wie es mit seinen Schnittstellen schematisch in Figur 2 gezeigt ist. Als zu berücksichtigende Parameter sind Eingänge mit Signalen für die Motordrehzahl, die Last, die Lage des oberen Totpunkts für Zylinder 1, die Temperatur von Öl, Wasser und Luft, die Kraftstoffsorte und den Luftdruck oder Ladedruck vorgesehen. Der erste Ausgang 90 dient der Abgabe des Signals zum Ein- und Ausschalten der Steuerspannung für den piezo-elektrischen Steller. Weitere Ausgänge am Steuergerät können beispielsweise die Abgasrückführung oder die Notabschaltung des Motors steuern.

## Patentansprüche

1. Piezo-elektrischer Steuerblock (68) in Verbindung mit einer Kraftstoffeinspritzanlage (3, 4) für einen Verbrennungsmotor, vorzugsweise Dieselmotor, mit einer Verteilereinspritzpumpe (4, 7) und einem nach verschiedenen Parametern einstellbaren Fördermengenstellglied (74), dadurch gekennzeichnet, daß der piezo-elektrische Steuerblock (68) aus mehreren piezo-elektrisch steuerbaren Biegestellern (76) zusammengesetzt ist, derart, daß zwischen die Biegelemente fest mit diesen verbundene Stege (88) aus verformbarem Material eingebracht sind, durch deren innere Reibung die Stellbewegung gedämpft wird.

2. Piezo-elektrischer Steuerblock nach Anspruch 1, dadurch gekennzeichnet, daß die Stege (88) aus Kunststoff gefertigt sind.

3. Piezo-elektrischer Steuerblock nach Anspruch 1, dadurch gekennzeichnet, daß die Stege (88) annähernd doppel-T-förmigen Querschnitt haben.

4. Piezo-elektrischer Steuerblock nach Anspruch 1, dadurch gekennzeichnet, daß die Stege zwischen benachbarten Biegelementen und senkrecht zu diesen angeordnet sind.

## Claims

1. Piezo-electric control block (68) in conjunction with a fuel injection unit (3, 4) for an internal combustion engine, preferably a diesel engine, with a distributor injection pump (4, 7) and a delivery rate actuator (74) adjustable in accordance with various parameters, characterized in that the piezo-electric control block (68) is composed of several piezo-electrically controllable bending actuators (76) in such a way that webs (88) of a deformable material joined firmly to the bending elements are introduced between the latter, the actuating movement being dampened by the internal friction of the webs.

2. Piezo-electric control block according to Claim 1, characterized in that the webs (88) are made of plastic.

3. Piezo-electric control block according to Claim 1, characterized in that the webs (88) have approximately an H-shaped cross-section.

4. Piezo-electric control block according to Claim 1, characterized in that the webs are arranged between adjacent bending elements and perpendicular to the latter.

## Revendications

1. Dispositif de commande piézoélectrique (68) destiné à une installation d'injection de carburant (3, 4) pour un moteur à combustion interne, de préférence un moteur Diesel, avec une pompe d'injection à répartition (4, 7) et un organe de réglage (74), réglable selon différents paramètres, pour la quantité de carburant refoulée, dispositif caractérisé en ce que le bloc de commande piézoélectrique (68) est composé de plusieurs organes de déplacement (76) susceptibles d'être commandés à la flexion, de sorte qu'entre ces éléments flexibles, sont insérées des entretoises (88) en un matériau déformable, reliées à ces éléments, et grâce à la friction interne desquelles le mouvement de déplacement est amorti.

2. Dispositif de commande piézoélectrique selon la revendication 1, caractérisé en ce que les entretoises (88) sont fabriquées en matière plastique.

3. Dispositif de commande piézoélectrique selon la revendication 1, caractérisé en ce que les entretoises (88) ont une section transversale approximativement en forme de double T.

4. Dispositif de commande piézoélectrique selon la revendication 1, caractérisé en ce que les entretoises sont disposées entre les éléments flexibles voisins et perpendiculairement par rapport à ceux-ci.

FIG.1

FIG.2

FIG.3

FIG.4

FIG.5

FIG.6